# EUROPEAN PATENT APPLICATION

(11) **EP 4 668 243 A1**
(43) Date of publication of application: **24.12.2025**
(21) Application number: 25183300.0
(22) Date of filing: 17.06.2025
(51) Int. Cl.: G08G 1/01, G06N 3/004, G06N 3/006, G06N 3/0464, G06N 3/08, G06N 20/00

(54) **SYSTEM AND METHOD FOR SIMULATING TRAFFIC USING AGENT-BASED MODELING**

(30) Priority: 17.06.2024 US 202418744893
(71) Applicant: Allstate Insurance Company, Northbrook, Illinois 60062 (US)
(72) Inventor: BANIKAZEMI, Reza Paul, Northbrook, 60062 (US); LINDER, Eric M., Northbrook, 60062 (US); WEN, Yicheng, Northbrook, 60062 (US); NENDORF, Robert Andrew, Northbrook, 60062 (US)
(74) Representative: Wallin, Nicholas James

(57) **Abstract**

Implementations claimed and described herein provide systems and methods for simulating traffic using synthetic data based on agent-based modeling that simulates real drivers in a particular geographic area and time frame. In one implementation, inputting, in a machine-learning model of a simulation system, real-world agent-based position data associated with a custom selection of a geographic area and a time frame. The machine-learning model of the simulation system outputs metrics associated with synthetic agent-based position data over time within a map for the simulated environment and the variation of the simulated environment, wherein the metrics represents synthetic movement behavior of agents associated with synthetic individuals based on real movement behavior associated with the geographic area and the time frame.

## Description

### PRIORITY CLAIM

This application claims priority from United States patent application no. 18/744893, filed 17 June 2024, the entire contents of which are incorporated herein for all purposes.

### FIELD

Aspects of the presently disclosed technology relate generally to simulating traffic using synthetic data based on agent-based modeling that simulates real-world driving behaviors in a particular geographic area and time frame.

### BACKGROUND

Traffic planners and traffic engineers may use models to analyze and help make planning decisions based on traffic flow. The issue with using most synthetic data is that they are fake or inaccurate, and just based on a couple of different assumptions, in representing the actual behavior of drivers in a particular area and/or at a particular time. Even random data has utility in helping determine potential areas of congestion but using real data that is intelligent as to where agents are trying to go at any given time would be more useful. However, using real data, such as raw GPS data based on real drivers, may face privacy issues. With these observations in mind, among others, various aspects of the present disclosure were conceived and developed.

### SUMMARY

Implementations described and claimed herein address the foregoing by providing systems and methods for simulating traffic using synthetic data based on agent-based modeling that simulates real-world driving behaviors in a particular geographic area and time frame.

In some implementations, real-world agent-based position data associated with a custom selection of a geographic area and a time frame is inputted into a machine-learning model of a simulation system. A simulated environment including movement constraints that represent the geographic area and a variation of the simulated environment based on one or more changes to the simulated environment may be created. The machine-learning model of the simulation system may output metrics associated with synthetic agent-based position data over time within a map for the simulated environment and the variation of the simulated environment. The metrics may represent synthetic movement behavior of synthetic agents associated with synthetic individuals based on real movement behavior associated with the geographic area and the time frame.

In some implementations, real-world agent-based position data associated with a geographic area and a time frame of a custom selection may be translated into narrativized instructions of the real-world agent-based position data. A large language machine-learning model of a simulation system may be trained based on the narrativized instructions of the real-world agent-based position data associated with the custom selection, to output metrics associated with synthetic agent-based position data over time. A simulated environment including movement constraints that represent the geographic area and a variation of the simulated environment based on one or more changes to the simulated environment may be created. Narrativized movement instructions associated with the synthetic agent-based position data over time within a map for the simulated environment and the variation of the simulated environment may be outputted from the large language machine-learning model of the simulation system. The narrativized movement instructions may represent synthetic movement behavior of synthetic agents associated with synthetic individuals based on real movement behavior associated with the geographic area and the time frame.

Other implementations are also described and recited herein. Further, while multiple implementations are disclosed, still other implementations of the presently disclosed technology will become apparent to those skilled in the art from the following detailed description, which shows and describes illustrative implementations of the presently disclosed technology. As will be realized, the presently disclosed technology is capable of modifications in various aspects, all without departing from the spirit and scope of the presently disclosed technology. Accordingly, the drawings and detailed descriptions are to be regarded as illustrative in nature and not limiting.

### BRIEF DESCRIPTION OF THE DRAWINGS

FIG. 1 illustrates an example diagram showing a simulation system for simulating traffic using synthetic data based on agent-based modeling that simulates real-world driving behaviors in a particular geographic area and time frame, in accordance with some aspects of the present technology.
FIG. 2 illustrates an example map with example synthetic data based on agent-based modeling, in accordance with some aspects of the present technology.
FIG. 3 illustrates an example network environment with one or more computing devices for simulating traffic using synthetic data based on agent-based modeling, in accordance with some aspects of the present technology.
FIG. 4 illustrates example operations for simulating traffic using synthetic data based on agent-based modeling that simulates real-world driving behaviors in a particular geographic area and time frame, in accordance with some aspects of the present technology.
FIG. 5 illustrates example operations for generating a visual representation of a variation of the simulated environment, in accordance with some aspects of the present technology.
FIG. 6 illustrates a visual representation of the example operation described.
FIG. 7 illustrates an example operation for outputting textual trips.
FIG. 8 illustrates an example neural network architecture in accordance with some aspects of the present technology.

### DETAILED DESCRIPTION

The detailed description set forth below is intended as a description of various configurations of embodiments and is not intended to represent the only configurations in which the subject matter of this disclosure can be practiced. The appended drawings are incorporated herein and constitute a part of the detailed description. The detailed description includes specific details for the purpose of providing a more thorough understanding of the subject matter of this disclosure. However, it will be clear and apparent that the subject matter of this disclosure is not limited to the specific details set forth herein and may be practiced without these details. In some instances, structures and components are shown in block diagram form to avoid obscuring the concepts of the subject matter of this disclosure.

Disclosed are systems, apparatuses, methods, non-transitory computer-readable media, and circuits for simulating traffic using synthetic data based on agent-based modeling that simulates real drivers in a particular geographic area and time frame. According to at least one example, a system comprising one or more processors, a display with a user interface, and a memory unit storing computer-executable instructions, which when executed by the one or more processors, cause the system to simulate traffic using synthetic data based on agent-based modeling. A machine-learning model may be trained to model a reinforcement learning algorithm that could help traffic planners and engineers. The traffic may be on a road to control vehicle congestion or control of any other type of human movement, such as movement through a stadium for safety, or for determining a business location based on pedestrian traffic. All such data requires real-world agent-based position data by individuals. However, in light of privacy-safety regulations and concerns, such real-world data cannot be utilized or sold freely. Therefore, there is a need for synthetic data that mimics as closely to real-world data as possible.

According to at least one example, the system may train a machine-learning model to translate real-world agent-based position data into narrativized instructions associated with each agent and then using the narrativized instructions to train the machine-learning model, such as a large language model, to generate synthetic movement data in a narrativized instructions form that represents synthetic movement behaviors of synthetic agents that are generated based on real movement behavior of individuals.

According to at least one example, a computer-implemented method is comprising inputting, in a machine-learning model of a simulation system, real-world agent-based position data associated with a custom selection of a geographic area and a time frame. According to at least one example, the computer-implemented method comprises creating a simulated environment including a movement constraints that represent the geographic area and a variation of the simulated environment based on one or more changes to the simulated environment. According to at least one example, the computer-implemented method comprises outputting, from the machine-learning model of the simulation system, metrics associated with synthetic agent-based position data over time within a map for the simulated environment and the variation of the simulated environment, wherein the metrics represents synthetic movement behavior of agents associated with synthetic individuals based on real movement behavior associated with the geographic area and the time frame.

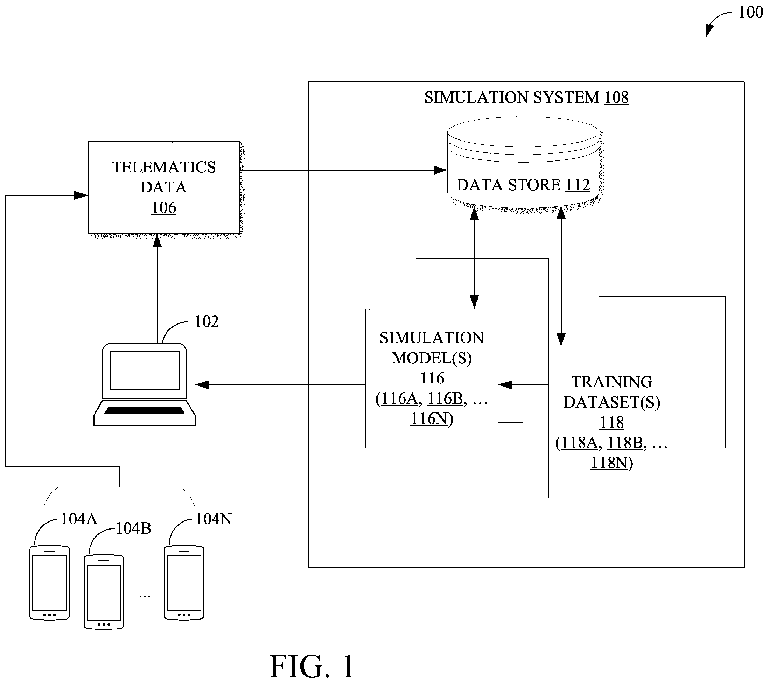

To begin a detailed description of an example diagram 100 showing a simulation system 108 for simulating traffic using synthetic data based on agent-based modeling that simulates real drivers in a particular geographic area and time frame is made to FIG. 1, in accordance with some aspects of the present technology. A device 102, such as a mobile device or some other form of telematics device, may collect telematics data 106. Telematics data 106 may be collected from a global position system (GPS), micro-electro-mechanical system (MEMS) sensors, and other data logging tools. The telematics data 106 captured can include location, speed, idling time, harsh acceleration or braking, vehicle faults, and more.

The telematics data 106 may be sent to the simulation system 108 to ultimately output metrics associated with synthetic agent-based position data over time within a map for a simulated environment and the variation of the simulated environment. The metrics may represent synthetic movement behavior of agents associated with synthetic individuals based on real movement behavior associated with the geographic area and the time frame. The simulation system 108 may comprise a remote processor, partially comprise the remote processor and use one or more processors on the device 102, or fully determine the prediction on one or more processors on the device 102. If the simulation system 108 is remote, data sent to and from a mobile application may be via an application programming interface (API).

The telematics data 106, which may include at least one of global positioning system (GPS) speed variables, GPS altitude variables, and accelerometer magnitude variables, may be stored at a data store 112 or at the device 102. In some cases, one or more simulation models 116 (116A, 116B, ... 116N) may include one or more machine-learning models and/or be a part of a convolutional neural network (CNN) of the simulation system 108. In some cases, each simulation model 116 may be associated with a different custom selection of a geographic area and time frame and trained by respective real-world agent-based position data associated with the custom selected geographic area and time frame. In some cases, each simulation model 116 may receive the telematics data 106 from the data store or may directly receive the telematics data 106.

In some cases, a simulated environment including a movement constraints that represent the geographic area may be created. In addition, a variation of the simulated environment based on one or more changes to the simulated environment may also be created. For example, where a synthetic agent is allowed to travel within a synthetic geographic area may be created in a gym environment that is customized to represent the geographic area based on a plurality of algorithms including physics-based algorithms.

The simulation model 116A may further translate the real-world agent-based position data from the telematics data 106 associated with the geographic area and the time frame of the custom selection into narrativized instructions of the real-world agent-based position data. In some cases, the simulation models are machine-learning models that are trained to receive the narrativized instructions of the real-world agent-based position data as inputs. In some cases, the machine-learning models are large language models (LLMs). In receiving the narrativized instructions of the real-world agent-based position data, the simulation model 116 may generate a simulated environment that includes a plurality of agents and a map with constraints that represent a real-world based on the custom selection of the geographic are and time frame.

In some cases, the simulation model 116 may receive the narrativized instructions of the real-world agent-based position data and be trained to output metrics associated with synthetic agent-based position data over time within a map for the simulated environment including the variation of the simulated environment. In some case, the metrics represents synthetic movement behavior of agents associated with synthetic individuals based on real movement behavior associated with the geographic area and the time frame.

As mentioned above, the real-world agent-based position data may include a plurality of different agents or individuals moving within the selected geographic area within a particular time frame. For example, if the selected geographic area is all of San Francisco or if the selected geographic area is only a 4-street diameter within San Francisco, the type of movement between such different geographic areas are also very different. The time range may also impact what type of movement data is used to generate the simulated data. If the time range is only rush hour, that's different that a 24-hour range. Furthermore, a custom level of detail of road inclusion as a part of the constraints may also vary. For example, if the geographic area covers San Francisco to Los Angeles, the types of roads that are to be included in the map is likely much less detailed than one with a 4-street diameter to take account for scale computation.

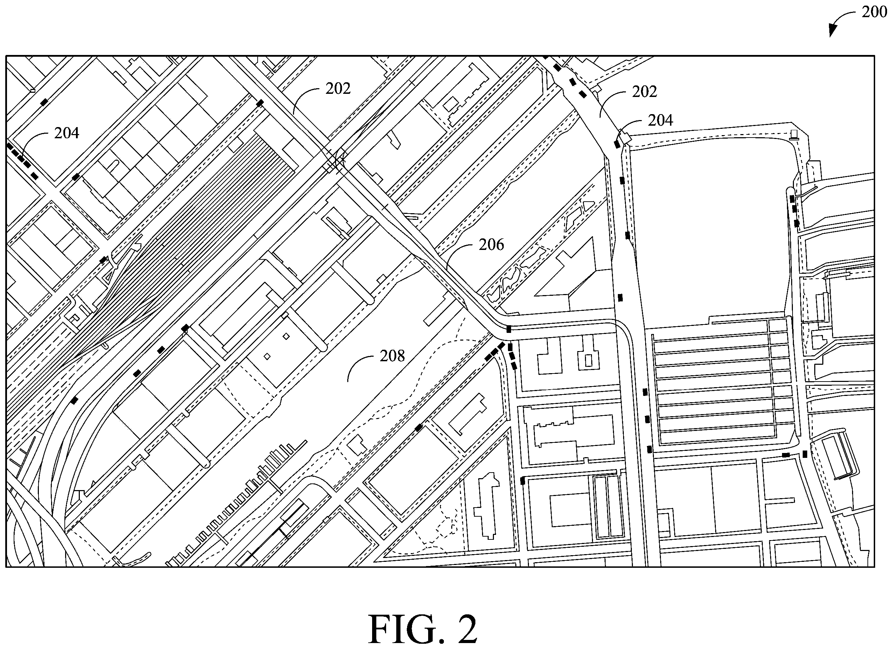

Turning to FIG. 2, the illustrated example diagram shows example visual representation of a variation of a simulated environment in accordance with some aspects of the present technology.

A visual representation 200 may include visual representations of streets 202 and visual representations of vehicles 204. In some cases, there may be visual representations of humans, such as pedestrians or bicyclists. In the visual representation 200, the visual representations of vehicles 204 may move over time to show agent-based position data over time. If the visual representation 200 is associated with synthetic data, the visual representations of vehicles 104 are not movement of actual humans but of synthetic agents generated from a machine-learning model based off of real-world agent-based position data. In some cases, a variation may be introduced to the simulated environment and the synthetic agents would move within the simulated environment including the variation. As such, traffic planner may use such data to determine whether such a variation will help with traffic flow or not.

Turning to the example of FIG. 2, a traffic planner may be interested in how a new bridge in addition to a pre-existing bridge 206 over water 208 may help with traffic. As such, the variation, a new bridge, may be added to the simulated environment and the synthetic agents would move as they normally would but with a new bridge option. For some of those synthetic agents, they will be trained to seek a fasted path to their destination across the bridge and may take the bridge, and for others, the bridge may not be a faster path and they may not seek to take the bridge. The traffic planner may review the synthetic traffic and determine whether adding the new bridge is helpful in alleviating traffic.

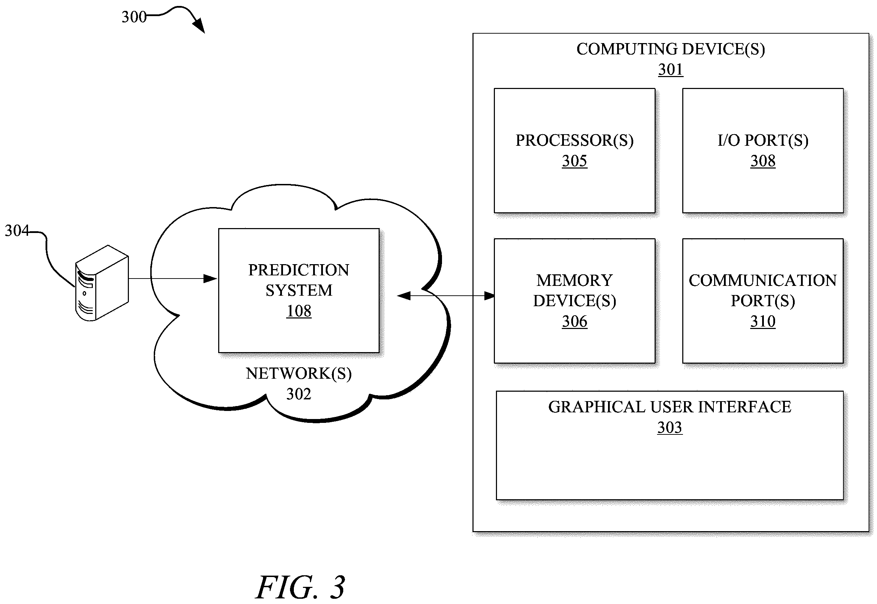

FIG. 3 illustrates an example network environment with one or more computing devices for generating a prediction for a likelihood of a collision based on a respective collision prediction algorithm for a particular type of impact in accordance with some aspects of the present technology. The example network environment 300 includes the one or more network(s) 302 which can be a cellular network such as a 3rd Generation Partnership Project (3GPP) network, a third generation (3G) network, a fourth generation (4G) network, a fifth generation (5G) network, a Long-Term Evolution (LTE), an LTE Advanced Network, a Global System for Mobile Communications (GSM) network, a Universal Mobile Telecommunications System (UMTS) network, and the like. Moreover, the network(s) 302 can include any type of network, such as the Internet, an intranet, a Virtual Private Network (VPN), a Voice over Internet Protocol (VoIP) network, a wireless network (e.g., Bluetooth), a cellular network, a satellite network, combinations thereof, etc.

In some cases, the device 102 runs software and/or a software development kit (SDK) that simulates traffic using synthetic data based on agent-based modeling that simulates real drivers in a particular geographic area and time frame. In some cases, the models and associated logic may be accessed remotely via the cloud and applied on the device 102. A local model may reside on the device 102 in the case the device 102 is offline.

The network(s) 302 provide access to and interactions with systems that simulate traffic using synthetic data based on agent-based modeling that simulates real drivers in a particular geographic area and time frame. The network(s) 302 can include communications network components such as, but not limited to gateways routers, servers, and registrars, which enable communication across the network(s) 302. In one implementation, the communications network components include multiple ingress/egress routers, which may have one or more ports, in communication with the network(s) 302. Communication via any of the networks can be wired, wireless, or any combination thereof.

The network environment 300 may also include at least one server device 304 hosting software, application(s), websites, and the like for operating the simulation system 108 for simulating traffic using synthetic data based on agent-based modeling that simulates real drivers in a particular geographic area and time frame. The simulation system 108 can receive inputs from various computing devices and transform the received input data into other unique types of data. The server(s) 304 may be a single server, a plurality of servers with each such server being a physical server or a virtual machine, or a collection of both physical servers and virtual machines.

In another implementation, a cloud hosts one or more components of the systems 100-300. The server(s) 304 may represent an instance among large instances of application servers in a cloud computing environment, a data center, or other computing environment. The server(s) 304 can access data stored at one or more database(s) (e.g., including any of the values or identifiers discussed herein). The systems 100-300, the server(s) 304, and/or other resources connected to the network(s) 302 may access one or more other servers to access other websites, applications, web services interfaces, GUIs, storage devices, APIs, computing devices, or the like to perform the techniques discussed herein. The server(s) can include one or more computing device(s) 301, as discussed in greater detail below.

For instance, the network environment 300 can include the one or more computing device(s) 301 for executing the simulation system 108 and/or simulating traffic using synthetic data based on agent-based modeling that simulates real drivers in a particular geographic area and time frame. In one implementation, the one or more computing device(s) 301 include the one or more server device(s) 304 executing the simulation system 108 as a software application and/or a module or algorithmic component of software.

In some instances, the computing device(s) 301 can include a computer, a personal computer, a desktop computer, a laptop computer, a terminal, a workstation, a server device, a cellular or mobile phone, a mobile device, a smart mobile device a tablet, a wearable device (e.g., a smart watch, smart glasses, a smart epidermal device, etc.) a multimedia console, a television, an Internet-of-Things (IoT) device, a smart home device, a medical device, a virtual reality (VR) or augmented reality (AR) device, a vehicle (e.g., a smart bicycle, an automobile computer, etc.), and/or the like. The computing device(s) 301 may be integrated with, form a part of, or otherwise be associated with the systems/network environments 100-300. It will be appreciated that specific implementations of these devices may be of differing possible specific computing architectures not all of which are specifically discussed herein but will be understood by those of ordinary skill in the art.

The computing device 301 may be a computing system capable of executing a computer program product to execute a computer process. Data and program files may be input to the computing device 301, which reads the files and executes the programs therein. Some of the elements of the computing device 301 include one or more hardware processors 305, one or more memory devices 306, and/or one or more ports, such as input/output (IO) port(s) 308 and communication port(s) 310. Additionally, other elements that will be recognized by those skilled in the art may be included in the computing device 301 but are not explicitly depicted in FIG. 1 or discussed further herein. Various elements of the computing device 301 may communicate with one another by way of the communication port(s) 310 and/or one or more communication buses, point-to-point communication paths, or other communication means.

The processor 305 may include, for example, a central processing unit (CPU), a microprocessor, a microcontroller, a digital signal processor (DSP), and/or one or more internal levels of cache. There may be one or more processors 305, such that the processor 305 comprises a single central-processing unit, or a plurality of processing units capable of executing instructions and performing operations in parallel with each other, commonly referred to as a parallel processing environment.

The computing device 301 may be a conventional computer, a distributed computer, or any other type of computer, such as one or more external computers made available via a cloud computing architecture. The presently described technology is optionally implemented in software stored on the data storage device(s) such as the memory device(s) 306, and/or communicated via one or more of the I/O port(s) 308 and the communication port(s) 310, thereby transforming the computing device 301 in FIG. 3 to a special purpose machine for implementing the operations described herein and generating a prediction for a likelihood of a collision based on a respective collision prediction algorithm for a particular type of impact. Moreover, the computing device 301, as implemented in the systems 100-300, receives various types of input data (e.g., in different data formats) and transforms the input data through the stages of the data flow described herein into new types of data files (e.g., metrics associated with real-world agent-based position data over time in the simulated environment). Moreover, these new data files are transformed to enable the computing device 301 to do something it could not do before-generate the simulation models 116.

The one or more memory device(s) 306 may include any non-volatile data storage device capable of storing data generated or employed within the computing device 301, such as computer executable instructions for performing a computer process, which may include instructions of both application programs and an operating system (OS) that manages the various components of the computing device 301. The memory device(s) 306 may include, without limitation, magnetic disk drives, optical disk drives, solid state drives (SSDs), flash drives, and the like. The memory device(s) 306 may include removable data storage media, non-removable data storage media, and/or external storage devices made available via a wired or wireless network architecture with such computer program products, including one or more database management products, web server products, application server products, and/or other additional software components. Examples of removable data storage media include Compact Disc Read-Only Memory (CD-ROM), Digital Versatile Disc Read-Only Memory (DVD-ROM), magneto-optical disks, flash drives, and the like. Examples of non-removable data storage media include internal magnetic hard disks, SSDs, and the like. The one or more memory device(s) 306 may include volatile memory (e.g., dynamic random-access memory (DRAM), static random-access memory (SRAM), etc.) and/or non-volatile memory (e.g., read-only memory (ROM), flash memory, etc.).

Computer program products containing mechanisms to effectuate the systems and methods in accordance with the presently described technology may reside in the memory device(s) 306 which may be referred to as machine-readable media. It will be appreciated that machine-readable media may include any tangible non-transitory medium that is capable of storing or encoding instructions to perform any one or more of the operations of the present disclosure for execution by a machine or that is capable of storing or encoding data structures and/or modules utilized by or associated with such instructions. Machine-readable media may include a single medium or multiple media (e.g., a centralized or distributed database, and/or associated caches and servers) that store the one or more executable instructions or data structures.

In some implementations, the computing device 301 includes one or more ports, such as the I/O port(s) 308 and the communication port(s) 310, for communicating with other computing or network devices. It will be appreciated that the I/O port 308 and the communication port 310 may be combined or separate and that more or fewer ports may be included in the computing device 301.

The I/O port 308 may be connected to an I/O device, or other device, by which information is input to or output from the computing device 301. Such I/O devices may include, without limitation, one or more input devices, output devices, and/or environment transducer devices.

In one implementation, the input devices convert a human-generated signal, such as, human voice, physical movement, physical touch or pressure, and/or the like, into electrical signals as input data into the computing device 301 via the I/O port 308. Similarly, the output devices may convert electrical signals received from the computing device 301 via the I/O port 308 into signals that may be sensed as output by a human, such as sound, light, and/or touch. The input device may be an alphanumeric input device, including alphanumeric and other keys for communicating information and/or command selections to the processor 305 via the I/O port 308. The input device may be another type of user input device including, but not limited to: direction and selection control devices, such as a mouse, a trackball, cursor direction keys, a joystick, and/or a wheel; one or more sensors, such as a camera, a microphone, a positional sensor, an orientation sensor, an inertial sensor, and/or an accelerometer; and/or a touch-sensitive display screen ("touchscreen"). The output devices may include, without limitation, a display, a touchscreen, a speaker, a tactile and/or haptic output device, and/or the like. In some implementations, the input device and the output device may be the same device, for example, in the case of a touchscreen.

In one implementation, the communication port 310 is connected to the network 302 so the computing device 301 can receive network data useful in executing the methods and systems set out herein as well as transmitting information and network configuration changes determined thereby. Stated differently, the communication port 310 connects the computing device 301 to one or more communication interface devices configured to transmit and/or receive information between the computing device 301 and other devices (e.g., network devices of the network(s) 302) by way of one or more wired or wireless communication networks or connections. Examples of such networks or connections include, without limitation, Universal Serial Bus (USB), Ethernet, Wi-Fi, Bluetooth^{®}, Near Field Communication (NFC), and so on. One or more such communication interface devices may be utilized via the communication port 310 to communicate with one or more other machines, either directly over a point-to-point communication path, over a wide area network (WAN) (e.g., the Internet), over a local area network (LAN), over a cellular network (e.g., third generation (3G), fourth generation (4G), Long-Term Evolution (LTE), fifth generation (5G), etc.) or over another communication means. Further, the communication port 310 may communicate with an antenna or other link for electromagnetic signal transmission and/or reception.

In an example, the simulation system 108 and/or other software, modules, services, and operations discussed herein may be embodied by instructions stored on the memory devices 306 and executed by the processor 305.

The system 300 set forth in FIG. 3 is but one possible example of a computing device 301 or computer system that may be configured in accordance with aspects of the present disclosure. It will be appreciated that other non-transitory tangible computer-readable storage media storing computer-executable instructions for implementing the presently disclosed technology on a computing system may be utilized. In the present disclosure, the methods disclosed may be implemented as sets of instructions or software readable by the computing device 301.

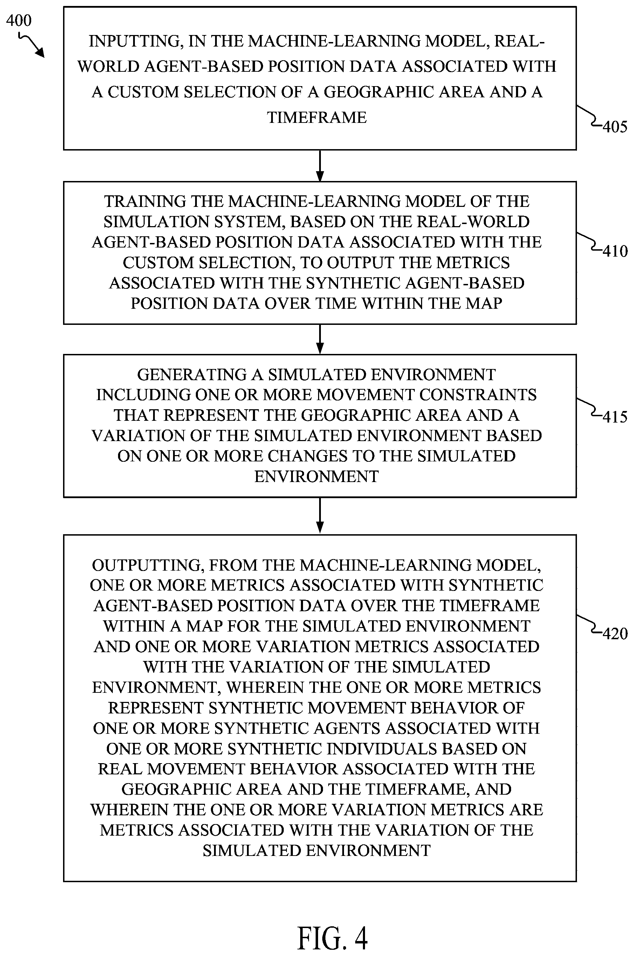

FIG. 4 illustrates example operations for simulating traffic using synthetic data based on agent-based modeling that simulates real drivers in a particular geographic area and time frame, which can be performed by any of the systems/network environments 100, 300. At operation 405, the method 400 includes inputting, in a machine-learning model of a simulation system, real-world agent-based position data associated with a custom selection of a geographic area and a time frame. For example, the real-world agent-based position data may include location data at given time intervals for each agent or individual in the geographic area. If the geographic area covers a mile radius and the time frame covers rush hour for a year, for example, the location data at a given time interval for each individual agent or individual that moves within the mile radius during rush hour for a year may be aggregated and inputted into the machine-learning model. At operation 410, the method 400 includes training the machine-learning model of the simulation system, based on the real-world agent-based position data associated with the custom selection, to output the metrics associated with the synthetic agent-based position data over time within the map. In other words, the machine-learning model may be trained to output similar but synthetic movement data.

At operation 415, the method 400 includes generating a simulated environment including one or more movement constraints that represent the geographic area and a variation of the simulated environment based on one or more changes to the simulated environment. In some cases, traffic engineers or planners may be interested in what would happen to traffic after a variation of the environment is introduced. For example, traffic engineers or planners may be curious whether or not adding a bridge would help traffic during rush hour. As such, a simulated environment that includes movement constraints, such as an underlying road network and stop light conditions, that represent the geographic area may be created. Similarly, a variation to the simulated environment based on one or more changes to the simulated environment may also be created. With the two different simulated environments, the outputs may then be compared to analyze whether or not the change is helpful with traffic congestion, if that is the concern.

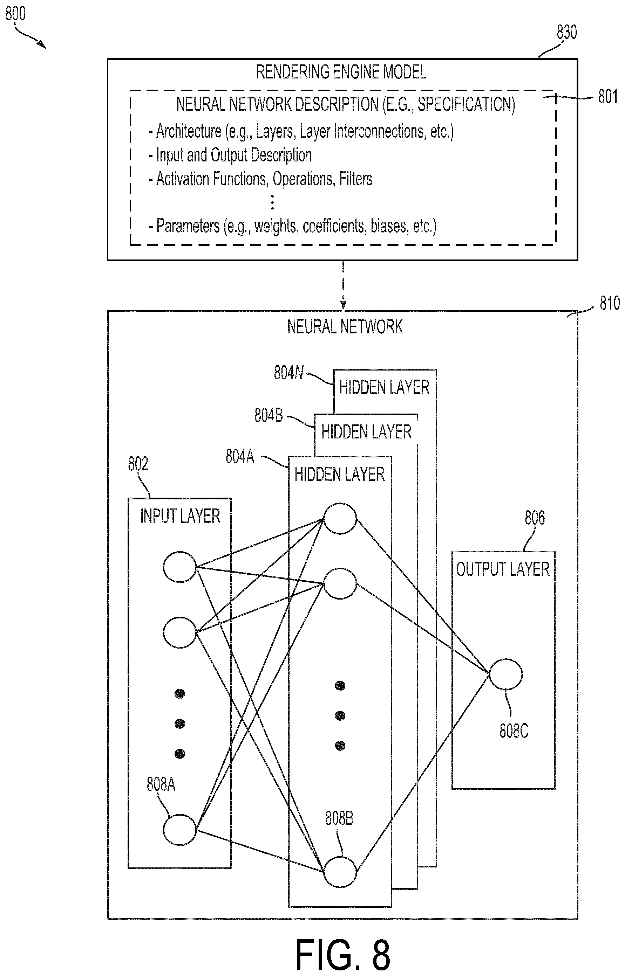

At operation 420, the method 400 includes outputting, from the machine-learning model, one or more metrics associated with synthetic agent-based position data over the timeframe within a map for the simulated environment and one or more variation metrics associated with the variation of the simulated environment. In some cases, the one or more metrics represent synthetic movement behavior of one or more synthetic agents associated with one or more synthetic individuals based on real movement behavior associated with the geographic area and the timeframe. In some case, the one or more variation metrics are metrics associated with the variation of the simulated environment. An analytical summary of one or more difference between the metrics and the variation metrics may be provided. In some cases, the comparison and the analytics summary may all be provided by the simulation models 116, which may be a machine-learning model, such as a large language model (LLM). An example of the simulation model 116 being a LLM is described in detail in FIG. 8.

The simulation model 116 being a LLM may further include a generative pre-trained transform (GPT) architecture that generates human-like text based on the input it receives. For example, the GPT model of the simulation model 116 may receive real-world agent-based position data associated with a custom selection of a geographic area and a time frame and translate such data into the narrativized instructions of the real-world agent-based position data. The simulation may also just receive the narrativized instructions of the real-world agent-based position data. Upon receiving either the real-world agent-based position data or the narrativized instructions thereof, the simulation model 116 may output metrics associated with synthetic agent-based position data over time within a map for the simulated environment and the variation of the simulated environment. In some cases, the metrics associated with synthetic agent-based position data may be translated from narrativized instructions of the synthetic agent-based position data.

In some cases, questions may be asked to the GPT model to receive more specific analysis regarding a comparison between the metrics associated with synthetic agent-based position data associated with the simulation environment or the variation of the simulated environment. For example, questions regarding where the most traffic congestion is in each environment may also help see how the variation may have shifted traffic congestion.

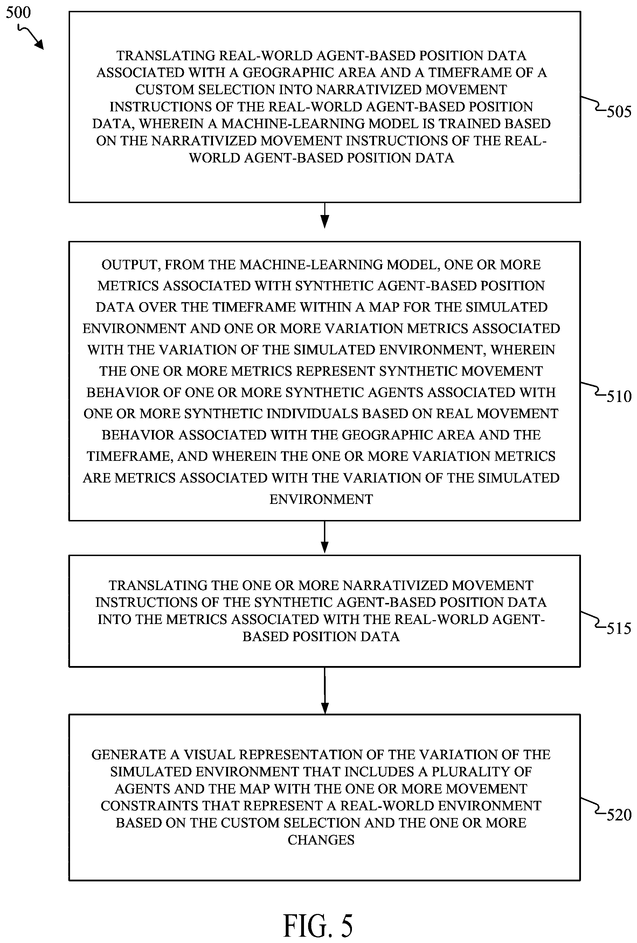

FIG. 5 illustrates example operations for generating a visual representation of a variation of the simulated environment, which can be performed by any of the systems 100-300 and/or network environment 300. At operation 505, the method 500 includes translating real-world agent-based position data associated with a geographic area and a timeframe of a custom selection into narrativized movement instructions of the real-world agent-based position data, wherein a machine-learning model is trained based on the narrativized movement instructions of the real-world agent-based position data. For example, real-world raw position data may include latitude and longitude position data over time whereas the narrativized instructions for each agent would be the driving instructions, such as a left turn on Venice Blvd and then a right turn onto 101 North.

At operation 510, the method 500 includes outputting, from the machine-learning model, one or more metrics associated with synthetic agent-based position data over the timeframe within a map for the simulated environment and one or more variation metrics associated with the variation of the simulated environment. In some cases, the one or more metrics represent synthetic movement behavior of one or more synthetic agents associated with one or more synthetic individuals based on real movement behavior associated with the geographic area and the timeframe. In some case, the one or more variation metrics are metrics associated with the variation of the simulated environment. The synthetic agents may be generated by the machine-learning model based on the real-world movement data of real-word agents, such that they are representative of the real-world agents but do not actually include any real-world data. In following the example of FIG. 2, if a real-world agent drives across the bridge to get from their apartment that is south of the bridge to work that is north of the bridge every morning, a synthetic agent may start from a different location that is south of the bridge and move through the bridge to get to a different direction north of the bridge.

The machine-learning model may further output textual trips that may be parsed and used to generate synthetic trips for the synthetic agents and/or aggregated behavioral predictions of the synthetic trips. To output the textual trips, a textualization process may be used and may include using map link identifiers to street names. Link distances may be summed up to find distance traveled on road. A sample bearing may be used to find a direction of travel. Street name transitions and bearing may be used to find turns and turning directions. For example, if heading north and then transitions to east, it is a right hand turn. An example textual trip may include an address as a starting point (e.g., 3553 W. 59th St.) and have textual directions, such as "To 2502 W 60th Pl: East on W 59th St to S Homan Ave, turn right onto S Homan Ave, turn left onto W 60th Pl, destination on the right. A prompt may be used to generate a block of trips such as an example prompt "generate a block of trips from 3553 W 59th St to 3400 W 60th St, assume that 59th and Homan Ave intersection is closed." Synthetic trips may be generated and aggregated behavior predictions may also be generated. For example, a number of vehicles that pass a particular link ID (or unique segment of the road) may be predicted in the simulation environment.

At operation 515, the method 500 includes translating the one or more narrativized movement instructions of the synthetic agent-based position data into the metrics associated with the real-world agent-based position data. Once the narrativized instructions of the synthetic agents are outputted from the machine-learning model, they may further be translated back into raw position data to be used to generate a visual representation, such as the example in FIG. 2.

At operation 520, the method 500 includes generate a visual representation of the variation of the simulated environment that includes a plurality of agents and the map with the one or more movement constraints that represent a real-world environment based on the custom selection and the one or more changes. In some cases, visual representations of the simulated environment and the variation of the simulated environment may be generated. For each, a plurality of agents and a map with constraints that represent a real-world environment based on the custom selection, and the one or more changes for the variation, may also be integrated into the visual representation.

It is to be understood that the specific order or hierarchy of operations in the methods depicted in FIGS. 4-5 and throughout this disclosure are instances of example approaches and can be rearranged while remaining within the disclosed subject matter. For instance, any of the operations depicted in FIGS. 4-5 may be omitted, repeated, performed in parallel, performed in a different order, and/or combined with any other of the operations depicted in FIGS. 4-5 or discussed herein.

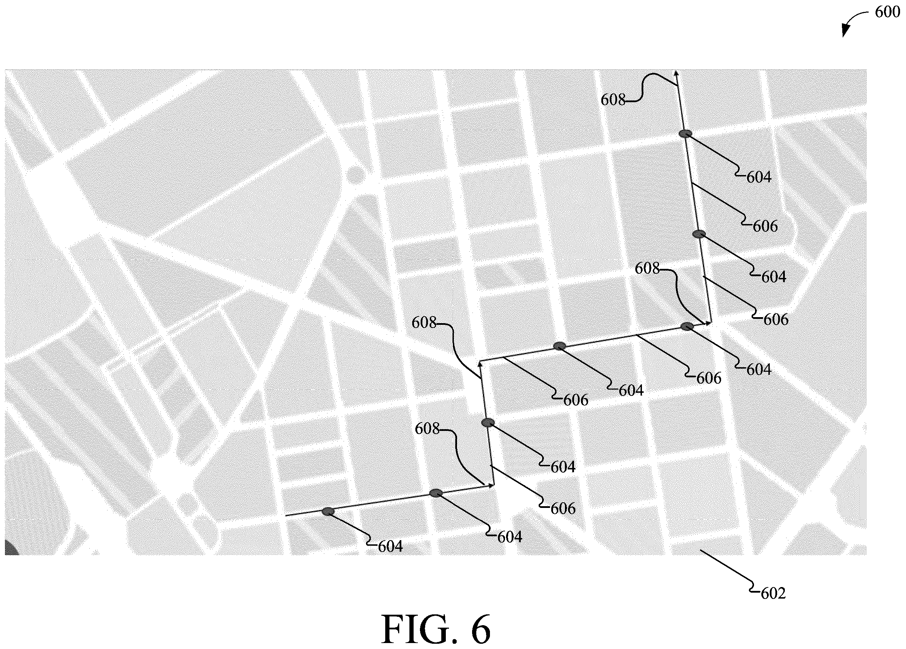

FIG. 6 depicts a visual representation 600 of the method 500 descripted above. A geographic area 602 is presented depicting a plurality of observed points 604 and a plurality of movements 606. Arrows 608 indicate a direction of travel.

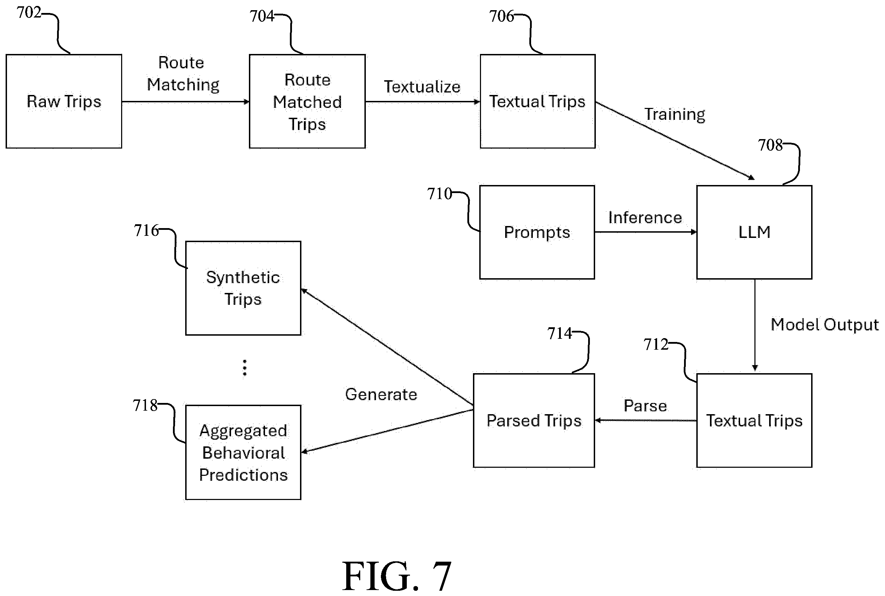

FIG. 7 depicts example operations for outputting textual trips, which can be performed by any of the systems 100-300 and/or network environment 300. At operation 702, the method 700 includes receiving raw trips and raw trip data. At operation 704, through route matching of the raw trips, trips are identified which share a common route. At operation 706, the trips are textualized, as described above. At operation 708, the textual trips are trained using a Large Language Model. In other embodiments, other machine learning models may be employed. At operation 710, prompts are provided to the Large Language Model, according to the method described above, At operation 712, the Large Language Model outputs the textual trips. At operation 714, the output textual trips are parsed. At operation 716, synthetic trips are generated and at operation, 718, aggregated behavioral predictions are generated.

FIG. 8 illustrates an example neural network architecture, in accordance with some aspects of the present technology. Architecture 800 includes a neural network 810 defined by an example neural network description 801 in rendering engine model (neural controller) 830. An example of a neural network 810 is the collision prediction CNN. Each neural network 810/collision prediction CNN may be associated with a particular type of impact or may have other neural network outputs associated with particular types of impact as the inputs. The neural network 810 can represent a neural network implementation of a rendering engine for rendering media data.

The neural network description 801 can include a full specification of the neural network 810, including the neural network architecture 800. For example, the neural network description 801 can include a description or specification of the architecture 800 of the neural network 810 (e.g., the layers, layer interconnections, number of nodes in each layer, etc.); an input and output description which indicates how the input and output are formed or processed; an indication of the activation functions in the neural network, the operations or filters in the neural network, etc.; neural network parameters such as weights, biases, etc.; and so forth.

The neural network 810 reflects the architecture 800 defined in the neural network description 801. In this example, the neural network 810 includes an input layer 802, which includes input data, such as kinematic variables including at least one of global positioning system (GPS) speed variables, GPS altitude variables, and accelerometer magnitude variables. In one illustrative example, the input layer 802 can include data representing a portion of the input media data such as a patch of data or pixels (e.g., a 128 x 128 patch of data) in an image corresponding to the input media data.

The neural network 810 includes hidden layers 804A through 804*N* (collectively "804" hereinafter). The hidden layers 804 can include *n* number of hidden layers, where *n* is an integer greater than or equal to one. The number of hidden layers can include as many layers as needed for a desired processing outcome and/or rendering intent. The neural network 810 further includes an output layer 806 that provides an output (e.g., paths that are outputted to a trained planning algorithm) resulting from the processing performed by the hidden layers 804. In one illustrative example, the output layer 806 can provide paths that are most likely to occur and a path that is considered an object collision path.

The neural network 810 in this example is a multi-layer neural network of interconnected nodes. Each node can represent a piece of information. Information associated with the nodes is shared among the different layers and each layer retains information as information is processed. In some cases, the neural network 810 can include a feed-forward neural network, in which case there are no feedback connections where outputs of the neural network are fed back into itself. In other cases, the neural network 810 can include a recurrent neural network, which can have loops that allow information to be carried across nodes while reading in input.

Information can be exchanged between nodes through node-to-node interconnections between the various layers. Nodes of the input layer 802 can activate a set of nodes in the first hidden layer 804A. For example, as shown, each of the input nodes of the input layer 802 is connected to each of the nodes of the first hidden layer 804A. The nodes of the hidden layer 804A can transform the information of each input node by applying activation functions to the information. The information derived from the transformation can then be passed to and can activate the nodes of the next hidden layer (e.g., 804B), which can perform their own designated functions. Example functions include convolutional, up-sampling, data transformation, pooling, and/or any other suitable functions.

The output of the hidden layer (e.g., 804B) can then activate nodes of the next hidden layer (e.g., 804N), and so on. The output of the last hidden layer can activate one or more nodes of the output layer 806, at which point an output is provided. In some cases, while nodes (e.g., nodes 808A, 808B, 808C) in the neural network 810 are shown as having multiple output lines, a node has a single output and all lines shown as being output from a node represent the same output value.

In some cases, each node or interconnection between nodes can have a weight that is a set of parameters derived from training the neural network 810. For example, an interconnection between nodes can represent a piece of information learned about the interconnected nodes. The interconnection can have a numeric weight that can be tuned (e.g., based on a training dataset), allowing the neural network 810 to be adaptive to inputs and able to learn as more data is processed.

The neural network 810 can be pre-trained to process the features from the data in the input layer 802 using the different hidden layers 804 in order to provide the output through the output layer 806. In an example in which the neural network 810 is used to output a prediction that the movement is not association with the first type of impact when the first prediction score is below a threshold score, the neural network 810 can be trained using training data that includes datasets from counterfactual collisions where movement was not associated with a first type of impact and actual historical instances associated with the first type of impact. For instance, training images can be input into the neural network 810, which can be processed by the neural network 810 to generate outputs which can be used to tune one or more aspects of the neural network 810, such as weights, biases, etc.

In some cases, the neural network 810 can adjust weights of nodes using a training process called backpropagation. Backpropagation can include a forward pass, a loss function, a backward pass, and a weight update. The forward pass, loss function, backward pass, and parameter update is performed for one training iteration. The process can be repeated for a certain number of iterations for each set of training media data until the weights of the layers are accurately tuned.

For a first training iteration for the neural network 810, the output can include values that do not give preference to any particular class due to the weights being randomly selected at initialization. For example, if the output is a vector with probabilities that the object includes different product(s) and/or different users, the probability value for each of the different product and/or user may be equal or at least very similar (e.g., for ten possible products or users, each class may have a probability value of 0.1). With the initial weights, the neural network 610 is unable to determine low level features and thus cannot make an accurate determination of what the classification of the object might be. A loss function can be used to analyze errors in the output. Any suitable loss function definition can be used.

The loss (or error) can be high for the first training dataset (e.g., images) since the actual values will be different than the predicted output. The goal of training is to minimize the amount of loss so that the predicted output comports with a target or ideal output. The neural network 810 can perform a backward pass by determining which inputs (weights) most contributed to the loss of the neural network 810, and can adjust the weights so that the loss decreases and is eventually minimized.

A derivative of the loss with respect to the weights can be computed to determine the weights that contributed most to the loss of the neural network 810. After the derivative is computed, a weight update can be performed by updating the weights of the filters. For example, the weights can be updated so that they change in the opposite direction of the gradient. A learning rate can be set to any suitable value, with a high learning rate including larger weight updates and a lower value indicating smaller weight updates.

The neural network 810 can include any suitable neural or deep learning network. One example includes a convolutional neural network (CNN), which includes an input layer and an output layer, with multiple hidden layers between the input and out layers. The hidden layers of a CNN include a series of convolutional, nonlinear, pooling (for downsampling), and fully connected layers. In other examples, the neural network 810 can represent any other neural or deep learning network, such as an autoencoder, a deep belief nets (DBNs), a recurrent neural networks (RNNs), etc.

Methods according to the above-described examples can be implemented using computer-executable instructions that are stored or otherwise available from computer-readable media. Such instructions can comprise, for example, instructions and data which cause or otherwise configure a general purpose computer, special purpose computer, or special purpose processing device to perform a certain function or group of functions. Portions of computer resources used can be accessible over a network. The executable computer instructions may be, for example, binaries, intermediate format instructions such as assembly language, firmware, or source code. Examples of computer-readable media that may be used to store instructions, information used, and/or information created during methods according to described examples include magnetic or optical disks, solid-state memory devices, flash memory, USB devices provided with non-volatile memory, networked storage devices, and so on.

Devices implementing methods according to these disclosures can comprise hardware, firmware and/or software, and can take any of a variety of form factors. Typical examples of such form factors include servers, laptops, smartphones, small form factor personal computers, personal digital assistants, and so on. The functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are means for providing the functions described in these disclosures.

Furthermore, any term of degree such as, but not limited to, "substantially," as used in the description and the appended claims, should be understood to include an exact, or a similar, but not exact configuration. Similarly, the terms "about" or "approximately," as used in the description and the appended claims, should be understood to include the recited values or a value that is three times greater or one third of the recited values. For example, about 3 mm includes all values from 1 mm to 9 mm, and approximately 50 degrees includes all values from 16.6 degrees to 150 degrees.

Lastly, the terms "or" and "and/or," as used herein, are to be interpreted as inclusive or meaning any one or any combination. Therefore, "A, B, or C" or "A, B, and/or C" mean any of the following: "A," "B," or "C"; "A and B"; "A and C"; "B and C"; "A, B and C." An exception to this definition will occur only when a combination of elements, functions, steps or acts are in some way inherently mutually exclusive.

While the present disclosure has been described with reference to various implementations, it will be understood that these implementations are illustrative and that the scope of the present disclosure is not limited to them. Many variations, modifications, additions, and improvements are possible. More generally, implementations in accordance with the present disclosure have been described in the context of particular implementations. Functionality may be separated or combined differently in various implementations of the disclosure or described with different terminology. These and other variations, modifications, additions, and improvements may fall within the scope of the disclosure as defined in the claims that follow.

There follows a list of numbered features defining particular embodiments of the present disclosure. Where a numbered feature refers to one or more other numbered features then those features should be considered in combination with each other.
1. A system comprising:
   one or more processors;
   one or more machine-learning models of a simulation system, wherein the one or more machine-learning models are associated with custom selections of geographic areas and timeframes; and
   one or more memory units storing computer-executable instructions, which when executed by the one or more processors, cause the system to:
      input, in one of the machine-learning models, real-world agent-based position data associated with one of the custom selections of one of the geographic areas and one of the timeframes;
      generate a simulated environment including one or more movement constraints that represent the one of the geographic areas and a variation of the simulated environment based on one or more changes to the simulated environment; and
      output, from the one of the machine-learning models, one or more metrics associated with synthetic agent-based position data over the one of the timeframes within a map for the simulated environment and one or more variation metrics associated with the variation of the simulated environment, wherein the one or more metrics represent synthetic movement behavior of one or more synthetic agents associated with one or more synthetic individuals based on real movement behavior associated with the geographic area and the timeframe, and wherein the one or more variation metrics represent synthetic movement behavior of the one or more synthetic agents associated with the one or more synthetic individuals in the variation of the simulated environment.
2. The system of feature 1, wherein the one or more processors further cause the system to:
   training the one of the machine-learning models of the simulation system, based on the real-world agent-based position data associated with the custom selection, to output the metrics associated with the synthetic agent-based position data over time within the map.
3. The system of feature 1 or 2, wherein the one or more processors further cause the system to:
   compare the one or more metrics with the one or more variation metrics; and
   provide an analytical summary of one or more difference between the one or more metrics and the one or more variation metrics.
4. The system of any of features 1 to 3, wherein the simulated environment is a gym environment that is customized to represent the geographic area based on a plurality of algorithms including physics-based algorithms.
5. The system of any of features 1 to 4, wherein the custom selection includes a custom level of detail of road inclusion as a part of the one or more movement constraints.
6. The system of any of features 1 to 5, wherein the one or more processors further cause the system to:
   generate a visual representation of the variation of the simulated environment that includes the one or more synthetic agents and the map with the one or more movement constraints that represent a real-world environment based on the custom selection and the one or more changes.
7. The system of any of features 1 to 6, wherein the real-world agent-based position data is based on vehicle movement data captured from one or more telematics sensors.
8. The system of any of features 1 to 7, wherein the one of the machine-learning models is a large language model and the synthetic agent-based position data includes one or more narrativized movement instructions associated with each agent.
9. The system of feature 8, further comprising:
   translating the one or more narrativized movement instructions of the synthetic agent-based position data into the metrics associated with the real-world agent-based position data.
10. The system of feature 9, further comprising:
   translating the real-world agent-based position data associated with the one of the geographic areas and the one of the timeframes of the one of the custom selections into narrativized movement instructions of the real-world agent-based position data, wherein the one of the machine-learning models is trained based on the narrativized movement instructions of the real-world agent-based position data.
11. A method comprising:
   training a machine-learning model of a simulation system, based on real-world agent-based position data associated with a custom selection of a geographic area and a time frame, to output metrics associated with synthetic agent-based position data over time within the geographic area;
   creating a simulated environment including movement constraints that represent the geographic area and a variation of the simulated environment based on one or more changes to the simulated environment; and
   outputting, from the machine-learning model of the simulation system, metrics associated with the synthetic agent-based position data over the time within a map for the simulated environment and variation metrics associated with the variation of the simulated environment, wherein the metrics represents synthetic movement behavior of synthetic agents associated with synthetic individuals based on real movement behavior associated with the geographic area and the time frame, and wherein the one or more variation metrics represent synthetic movement behavior of the one or more synthetic agents associated with the one or more synthetic individuals in the variation of the simulated environment.
12. The method of feature 11, wherein the simulated environment is a gym environment that is customized to represent the geographic area based on a plurality of algorithms including physics-based algorithms.
13. The method of feature 11 or 12, further comprising:
   comparing the metrics with the variation metrics; and
   providing an analytical summary of one or more difference between the metrics and the variation metrics.
14. The method of any of features 11 to 13, wherein the custom selection includes a custom level of detail of road inclusion as a part of the movement constraints.
15. The method of any of features 11 to 14, wherein the machine-learning model is a large language model and the synthetic agent-based position data includes narrativized movement instructions associated with each agent.
16. The method of feature 15, further comprising:
   translating the narrativized movement instructions of the synthetic agent-based position data into the metrics associated with the real-world agent-based position data.
17. The method of feature 16, further comprising:
   translating the real-world agent-based position data associated with the geographic area and the time frame of the custom selection into narrativized instructions of the real-world agent-based position data, wherein the machine-learning model is trained based on the narrativized instructions of the real-world agent-based position data.
18. One or more tangible non-transitory computer-readable storage media storing computer-executable instructions for performing a computer process on a computing system, the computer process comprising:
   translating real-world agent-based position data associated with a geographic area and a time frame of a custom selection into narrativized instructions of the real-world agent-based position data;
   training a large language machine-learning model of a simulation system, based on the narrativized instructions of the real-world agent-based position data associated with the custom selection, to output metrics associated with synthetic agent-based position data over time;
   generating a simulated environment including movement constraints that represent the geographic area and a variation of the simulated environment based on one or more changes to the simulated environment; and
   outputting, from the large language machine-learning model of the simulation system, narrativized movement instructions associated with the synthetic agent-based position data over time within a map for the simulated environment and the variation of the simulated environment, wherein the narrativized movement instructions represents synthetic movement behavior of synthetic agents associated with synthetic individuals based on real movement behavior associated with the geographic area and the time frame, and wherein the one or more variation metrics represent synthetic movement behavior of the one or more synthetic agents associated with the one or more synthetic individuals in the variation of the simulated environment.
19. The one or more tangible non-transitory computer-readable storage media of feature 18, the computer process further comprising:
   translating the narrativized movement instructions of the synthetic agent-based position data into variation metrics associated with the real-world agent-based position data.
20. The one or more tangible non-transitory computer-readable storage media of feature 19, the computer process further comprising:
   compare the real-world agent-based position data with variation real-world agent-based position data, wherein the variation real-world agent-based position data are associated with the variation of the simulated environment; and
   provide an analytical summary of one or more difference between the metrics and the variation metrics.

## Claims

1. A system comprising:
one or more processors;
one or more machine-learning models of a simulation system, wherein the one or more machine-learning models are associated with custom selections of geographic areas and timeframes; and
one or more memory units storing computer-executable instructions, which when executed by the one or more processors, cause the system to:
input, in one of the machine-learning models, real-world agent-based position data associated with one of the custom selections of one of the geographic areas and one of the timeframes;
generate a simulated environment including one or more movement constraints that represent the one of the geographic areas and a variation of the simulated environment based on one or more changes to the simulated environment; and
output, from the one of the machine-learning models, one or more metrics associated with synthetic agent-based position data over the one of the timeframes within a map for the simulated environment and one or more variation metrics associated with the variation of the simulated environment, wherein the one or more metrics represent synthetic movement behavior of one or more synthetic agents associated with one or more synthetic individuals based on real movement behavior associated with the geographic area and the timeframe, and wherein the one or more variation metrics represent synthetic movement behavior of the one or more synthetic agents associated with the one or more synthetic individuals in the variation of the simulated environment.

2. The system of claim 1, wherein the one or more processors further cause the system to:
training the one of the machine-learning models of the simulation system, based on the real-world agent-based position data associated with the custom selection, to output the metrics associated with the synthetic agent-based position data over time within the map.

3. The system of claim 1 or 2, wherein the one or more processors further cause the system to:
compare the one or more metrics with the one or more variation metrics; and
provide an analytical summary of one or more difference between the one or more metrics and the one or more variation metrics.

4. The system of any of claims 1 to 3, wherein the one or more processors further cause the system to:
generate a visual representation of the variation of the simulated environment that includes the one or more synthetic agents and the map with the one or more movement constraints that represent a real-world environment based on the custom selection and the one or more changes.

5. The system of any of claims 1 to 4, wherein the real-world agent-based position data is based on vehicle movement data captured from one or more telematics sensors.

6. A method comprising:
training a machine-learning model of a simulation system, based on real-world agent-based position data associated with a custom selection of a geographic area and a time frame, to output metrics associated with synthetic agent-based position data over time within the geographic area;
creating a simulated environment including movement constraints that represent the geographic area and a variation of the simulated environment based on one or more changes to the simulated environment; and
outputting, from the machine-learning model of the simulation system, metrics associated with the synthetic agent-based position data over the time within a map for the simulated environment and variation metrics associated with the variation of the simulated environment, wherein the metrics represents synthetic movement behavior of synthetic agents associated with synthetic individuals based on real movement behavior associated with the geographic area and the time frame, and wherein the one or more variation metrics represent synthetic movement behavior of the one or more synthetic agents associated with the one or more synthetic individuals in the variation of the simulated environment.

7. The method of claim 6, or the system of any of claims 1 to 3, wherein the simulated environment is a gym environment that is customized to represent the geographic area based on a plurality of algorithms including physics-based algorithms.

8. The method of claim 6 or 7, further comprising:
comparing the metrics with the variation metrics; and
providing an analytical summary of one or more difference between the metrics and the variation metrics.

9. The method of any of claims 6 to 8, or the system of any of claims 1 to 3, or 7, wherein the custom selection includes a custom level of detail of road inclusion as a part of the movement constraints.

10. The method of any of claims 6 to 9, or the system of any of claims 1 to 5, 7, or 9, wherein the machine-learning model is a large language model and the synthetic agent-based position data includes narrativized movement instructions associated with each agent.

11. The method or system of claim 10, further comprising:
translating the narrativized movement instructions of the synthetic agent-based position data into the metrics associated with the real-world agent-based position data.

12. The method or system of claim 11, further comprising:
translating the real-world agent-based position data associated with the geographic area and the time frame of the custom selection into narrativized instructions of the real-world agent-based position data, wherein the machine-learning model is trained based on the narrativized instructions of the real-world agent-based position data.

13. One or more tangible non-transitory computer-readable storage media storing computer-executable instructions for performing a computer process on a computing system, the computer process comprising:
translating real-world agent-based position data associated with a geographic area and a time frame of a custom selection into narrativized instructions of the real-world agent-based position data;
training a large language machine-learning model of a simulation system, based on the narrativized instructions of the real-world agent-based position data associated with the custom selection, to output metrics associated with synthetic agent-based position data over time;
generating a simulated environment including movement constraints that represent the geographic area and a variation of the simulated environment based on one or more changes to the simulated environment; and
outputting, from the large language machine-learning model of the simulation system, narrativized movement instructions associated with the synthetic agent-based position data over time within a map for the simulated environment and the variation of the simulated environment, wherein the narrativized movement instructions represents synthetic movement behavior of synthetic agents associated with synthetic individuals based on real movement behavior associated with the geographic area and the time frame, and wherein the one or more variation metrics represent synthetic movement behavior of the one or more synthetic agents associated with the one or more synthetic individuals in the variation of the simulated environment.

14. The one or more tangible non-transitory computer-readable storage media of claim 13, the computer process further comprising:
translating the narrativized movement instructions of the synthetic agent-based position data into variation metrics associated with the real-world agent-based position data.

15. The one or more tangible non-transitory computer-readable storage media of claim 14, the computer process further comprising:
compare the real-world agent-based position data with variation real-world agent-based position data, wherein the variation real-world agent-based position data are associated with the variation of the simulated environment; and
provide an analytical summary of one or more difference between the metrics and the variation metrics.
